# EUROPEAN PATENT APPLICATION

(11) **EP 1 591 818 A1**
(43) Date of publication of application: **02.11.2005**
(21) Application number: 04707309.3
(22) Date of filing: 02.02.2004
(51) Int. Cl.: G02B 7/04

(54) **IMAGE PICKUP DEVICE AND MOBILE TERMINAL DEVICE USING THE IMAGE PICKUP DEVICE**

(30) Priority: 03.02.2003 JP 2003026137
(71) Applicant: KONICA MINOLTA HOLDINGS, INC., Tokyo 100-0005 (JP)
(72) Inventor: NAKAMOTO, Satoshi, Hachioji-shi , Tokyo 1928505 (JP); MIZUKAMI, Masafumi, Hachioji-shi , Tokyo 1928505 (JP); KAKITA, Tsuyoshi, Hachioji-shi , Tokyo 1928505 (JP); ATARASHI, Yuuichi, Hachioji-shi , Tokyo 1928505 (JP)
(74) Representative: Henkel, Feiler & Hänzel
(86) International application number: PCT/JP2004/001005
(87) International publication number: WO 2004/070448

(57) **Abstract**

There are provided a highly accurate imaging apparatus which relatively rarely requires a cost and manufacturing troubles and can readily adjust a focal point, and a portable terminal apparatus comprising this imaging apparatus. According to the imaging apparatus (100) of the present invention, a lid member (3d) is attached to a mirror frame (3) in such a manner that the lid member can move along an optical axis (Y), a first pressing member (6) which presses an optical member toward a substrate side is elastically interposed between the lid member (3d) and the optical member (1), a second pressing member (7) which presses the optical member (1) toward the lid member (3d) is elastically interposed between the mirror frame (3) and the optical member (1), a pressing force of the first pressing member (6) is larger than a pressing force of the second pressing member (7) in a state where the optical member (1) is in contact with the upper surface of the imaging element (2), and the pressing force of the second pressing member (7) becomes larger than the pressing force of the first pressing member (6) and the optical member (1) is moved frontward along the optical axis (Y) to come into contact with a protruding portion (3e) protruding from an inner peripheral surface of the mirror frame (3) when the lid member (3d) moves frontward along the optical axis (1) over a predetermined distance.

## Description

### Technical Field:

The present invention relates to an imaging apparatus which can be mounted in a mobile phone or a personal computer, and a portable terminal apparatus comprising the imaging apparatus.

### Background Art:

In recent years, many portable information terminal apparatus (which will be referred to as a portable terminal apparatus hereinafter) having an imaging function such as a mobile phone in which a small high-performance imaging apparatus is mounted have been developed.

As such conventional portable terminal apparatuses, there is one which can perform regular imaging as well as close-up photography or close-up shooting (which will be referred to as macro shooting hereinafter) which images a character or the like in a magazine or a card (see, e.g., Japanese Patent Application Laid-open No. 2002-262164).

In the portable terminal apparatus disclosed in this publication, an imaging apparatus is attached to a terminal apparatus main body (an electronic device main body) so as to be capable of swiveling. In detail, this portable terminal apparatus comprises a plate fixedly provided to the terminal apparatus main body, a cam groove provided to this plate, and a protruding portion which engages with the cam groove in a frame body of a lens which integrally swivels with an imaging apparatus, and a distance between lenses is adjusted when a plurality of lenses swivels while being restricted by the cam groove with the swiveling motion of the imaging device, thereby enabling adjustment to obtain a magnifying power suitable for the macro shooting.

In the portable terminal apparatus disclosed in the above publication, however, since the cam groove must be provided to the plate or the protruding portion must be provided to the frame body of the lens, the mechanism is complicated, thus requiring an increase in cost or manufacturing troubles. Further, since a focal point is adjusted by the complicated mechanism, the cam manufacturing accuracy is required, and the lens attachment accuracy/assembling accuracy must be high. Furthermore, when performing the adjustment to obtain a plurality of magnifying powers, since a plurality of components must be moved, any component becomes loose by the repeated use, which may possibly result in an out-of-focus problem.

Moreover, in the portable terminal apparatus disclosed in the above publication, since the main body must be again held in accordance with a direction of a subject in order to swivel the imaging apparatus when switching a focal distance to perform the shooting, there is a problem of the inconvenience for a user.

Thus, in order to eliminate the above-described inconvenience in the prior art, it is an object of the present invention to provide a highly accurate imaging apparatus which does not relatively require a high cost and manufacturing troubles and can easily adjust a focal point, and a portable terminal apparatus comprising this imaging apparatus.

### Disclosure of the Invention:

To achieve this aim, according to a first aspect of the present invention, there is provided an imaging apparatus having: a substrate having an imaging element provided on an upper surface thereof; an optical member which is separably in contact with the substrate or the upper surface of the imaging element and condenses an incident light on the imaging element; and an outer frame member which covers the imaging element and the optical member and comprises a main body member fixedly provided on the substrate, a lid member attached on an end side of the main body member in such a manner that the lid member can move along an optical axis of the optical member, and a protruding portion which is fixedly provided at a predetermined position between the optical member and the lid member to protrude inwardly in a radial direction from an inner peripheral surface of the main body member, the imaging apparatus comprising:
a first pressing member which is elastically interposed between the lid member and the optical member and presses the optical member toward the substrate side; and
a second pressing member which is elastically interposed between a support member formed below the main body member and the optical member and presses the optical member toward the lid member side,
wherein a pressing force of the first pressing member is larger than a pressing force of the second pressing member in a state where the optical member is in contact with the substrate or the imaging element, and the pressing force of the second pressing member is larger than the pressing force of the first pressing member and the optical member moves frontward along the optical axis to come into contact with the protruding portion in a state where the lid member is moved frontward along the optical axis over a predetermined distance.

According to the first aspect, the lid member is attached at an end of the outer frame member in such a manner that the lid member can move along an optical axis, the protruding portion which protrudes inward in the radial direction from the inner peripheral surface of the main body member is provided between the optical member and the lid member, the first pressing member which presses the optical member toward the substrate side is elastically interposed between the lid member and the optical member, and the second pressing member which presses the optical member toward the lid member side is elastically interposed between the support member formed below the main body member and the optical member. Additionally, the pressing force of the first pressing member is larger than the pressing force of the second pressing member in a state where the optical member is in contact with the substrate or the imaging element, and the pressing force of the second pressing member becomes larger than the pressing force of the first pressing member and the optical member moves frontward along the optical axis to come into contact with the protruding portion when the lid member moves frontward along the optical axis over a predetermined distance. Therefore, the imaging apparatus can perform imaging processing based on two focal distances, i.e., a focal distance when the optical member is in contact with the substrate or the imaging element and a focal distance when the optical member is in contact with the protruding portion. Further, when the both focal distances are formed, the optical member is positioned by contact with the substrate or the imaging element or contact with the protruding portion by the first pressing member and the second pressing member, thereby realizing the accurate optical function. Furthermore, since the focal distances can be adjusted or switched by the arrangement of simple members such as the pressing members or movement of the lid member, the optical function can be diversified without requiring a high manufacturing cost or trouble.

According to a second aspect of the present invention, there is provided the imaging apparatus characterized in that the lid member described in the first aspect is screwed to the main body member, and the lid member moves along the optical axis by rotating the lid member.

According to the second aspect, the same advantages as those of the imaging apparatus described in the first aspect can be of course obtained and, since the lid member is screwed to the main body member and can move along the optical axis by rotating the lid member, the movement of the lid member can be realized without including a complicated mechanism, thereby diversifying the optical function without requiring a high cost and trouble of the imaging apparatus.

According to a third aspect of the present invention, there is provided the imaging apparatus characterized in that the optical member described in the first or second aspect comprises an extending portion which extends to the side and supports the second pressing member on a rear surface thereof, and the main body member comprises a support portion which protrudes from the inner peripheral surface and supports the second pressing member on a front surface thereof.

According to the third aspect, the same advantages as those of the imaging apparatus described in the first and second aspects can be of course obtained and, in particular, since the second pressing member is supported between the rear surface of the extending portion which extends to the side of the optical member and the front surface of the support portion which protrudes from the inner peripheral surface of the main body member, the second pressing member does not come into contact with the substrate or the imaging element even when the pressing force is applied in such a manner that the optical member is brought into contact with the substrate or the imaging element by the first pressing member, thereby protecting the substrate or the imaging element.

To achieve the above-described aim, according to a fourth aspect of the present invention, there is provided an imaging apparatus having: a substrate having an imaging element provided on an upper surface thereof; an optical member which is separably in contact with the substrate or the upper surface of the imaging element, comprises a front optical member and a rear optical member which are laminated in a cross direction so that they have the same optical axis, and condenses an incident light on the imaging element; and an outer frame member which covers the imaging element and the optical member, and comprises a main body member fixedly provided on the substrate, a lid member attached on an end side of the main body member in such a manner that the lid member can move along an optical axis of the optical member, and a protruding portion which is fixedly provided at a predetermined position between the optical member and the lid member to protrude inwardly in a radial direction from an inner peripheral surface of the main body member, the imaging apparatus comprising:
a first pressing member which is elastically interposed between the lid member and the front optical member and presses the front optical member toward the rear optical member side;
a second pressing member which is elastically interposed between the front optical member and the rear optical member and presses the front optical member toward the lid member side; and
a third pressing member which presses the rear optical member toward the substrate side,
wherein a pressing force of the first pressing member is larger than a pressing force of the second pressing member in a state where the front optical member is in contact with the rear optical member, and the pressing force of the second pressing member is larger than the pressing force of the first pressing member and the front optical member moves frontward along the optical axis to come into contact with the protruding portion in a state where the lid member is moved frontward along the optical axis over a predetermined distance.

According to the fourth aspect, the optical member comprises the front optical member and the rear optical member laminated in the vertical direction to have the equal optical axis, the lid member movable along the optical axis is attached at the front end of the main body member of the outer frame member, the protruding portion which protrudes from the inner peripheral surface of the main body member is provided between the front optical member and the lid member, the first pressing member which presses the optical member toward the rear optical member side is elastically interposed between the lid member and the front optical member, the second pressing member which presses the front optical member toward the lid member side is elastically interposed between the front optical member and the rear optical member, and the third pressing member which presses the rear optical member toward the substrate side is provided. Further, the pressing force of the first pressing member becomes larger than the pressing force of the second pressing member in a state where the front optical member is in contact with the rear optical member, and the pressing force of the second pressing member becomes larger than the pressing force of the first pressing member and the front optical member moves frontward along the optical axis to come into contact with the protruding portion when the lid member moves frontward along the optical axis over a predetermined distance. Therefore, the imaging apparatus can perform two types of focal point adjustment, i.e., imaging based on a focal distance when the front optical member is in contact with the rear optical member and imaging based on a focal distance when the front optical member is in contact with the protruding portion. Further, since the front optical member comes into contact with the rear optical member or the protruding portion and is thus positioned by the first and second pressing members when the both focal distances are formed, the accurate optical function can be realized. Furthermore, since the focal point adjustment based on the movement of the front optical member is realized by the movement of the lid member and the arrangement of the pressing members, the optical function can be diversified without requiring a cost and troubles in manufacture of the imaging apparatus.

Moreover, since the optical member is divided into the front optical member and the rear optical member and the front optical member alone is moved to perform the focal point adjustment, the moving optical member can be further reduced in size, and the pressing members and others can be miniaturized, thereby further reducing the size.

According to a fifth aspect of the present invention, there is provided the imaging apparatus characterized in that the lid member described in one of the first to fourth aspects is formed of a shape-memory alloy, and configured to be deformed and moved along the optical axis when heated.

According to the fifth aspect, the same advantages as those of the imaging apparatus described in one of the first to fourth aspects can be of course obtained and, in particular, since the lid member is formed of a shape-memory alloy and configured to be deformed by heating to move along the optical axis, the lid member can be moved when heated by, e.g., energization, thereby easily and automatically facilitating the movement of the lid member.

According to a sixth aspect of the present invention, there is provided a portable terminal apparatus comprising the imaging apparatus described in one of the first to fifth aspects.

According to the sixth aspect, the portable terminal apparatus comprising the imaging apparatus described in one of the first to fifth aspects can realize diversification of an imaging function based on the imaging apparatus.

According to a seventh aspect of the present invention, there is provided the portable terminal apparatus described in the sixth aspect characterized by comprising movement controlling means for performing the control to move the lid member of the imaging apparatus along the optical axis.

According to the seventh aspect, the same advantages as those of the portable terminal device described in the sixth aspect can be of course obtained and, in particular, since the movement controlling means for controlling the movement of the lid member of the imaging apparatus along the optical axis is provided, switching of focal distances of the imaging apparatus can be automatically performed, thereby improving the usability of a user.

### Brief Description of the Drawings:

FIG. 1 is a partially eliminated perspective view of an imaging apparatus according to an embodiment of the present invention;
FIG. 2 is a cross-sectional view showing a regular imaging mode state of the imaging apparatus taken along a line II-II in FIG. 1;
FIG. 3 is a cross-sectional view showing a macro imaging mode state of the imaging apparatus taken along the line II-II in FIG. 1;
FIG. 4 is a cross-sectional view showing a regular imaging mode state in a modification of the imaging apparatus depicted in FIG. 1;
FIG. 5 is a cross-sectional view showing a macro imaging mode state in a modification of the imaging apparatus depicted in FIG. 1;
FIGS. 6A and 6B are respectively a front view and a rear view showing an example of a mobile phone comprising the imaging apparatus according to the present invention;
FIG. 7 is a block diagram illustrating an internal configuration of the mobile phone depicted in FIG. 6; and
FIG. 8 is a flowchart illustrating imaging control processing by the mobile phone depicted in FIG. 6.

### Best Mode for Carrying out the Invention:

A preferred embodiment according to the present invention will now be described in detail hereinafter with reference to the accompanying drawings.

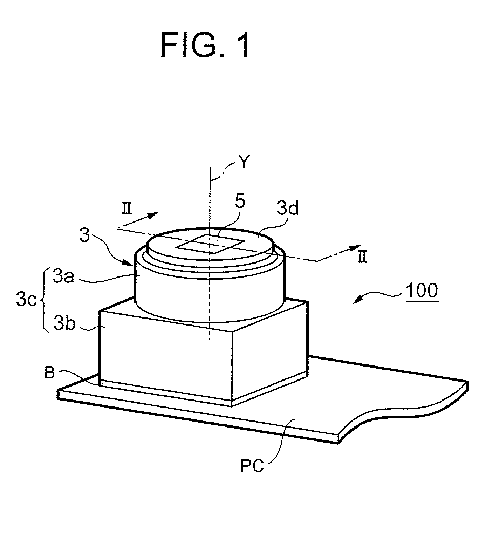

It is to be noted that the following description will be given on the assumption that a cross direction along an optical axis Y in an imaging apparatus according to the present invention is a vertical direction in the diagrammatic representation in FIGS. 1 to 3.

Here, a macro imaging mode is determined as a mode which is used to perform imaging apparatus suitable for approach shooting or close-up shooting in which a shooting distance (a distance between a lens and a subject) is shorter than that in a regular imaging mode.

As shown in FIGS. 1 to 3, an imaging apparatus 100 comprises: a substrate PC; an imaging element 2 which is arranged on one surface (an upper surface in the drawing) of the substrate PC; an optical member 1 which condenses a light in an imaging area (a later-described photoelectric conversion portion 2a) of this imaging element 2 and forms a subject image; a mirror frame 3 which covers and hides the optical member 1 and the imaging element 2; a douser 4 which is provided to the mirror frame (an outer frame member) 3 and has the light shielding properties; an IR cut filter 5 which is supported by the douser 4; a first pressing member 6 which is provided above the optical member 1 and presses the optical member 1 downward (rearward along the optical axis Y); a second pressing member 7 which is provided below the optical member 1 and presses the optical member 1 upward (frontward along the optical axis Y); and a positioning electrical component 8 which is attached to the substrate PC and positions the mirror frame 3 with respect to the substrate PC; and others.

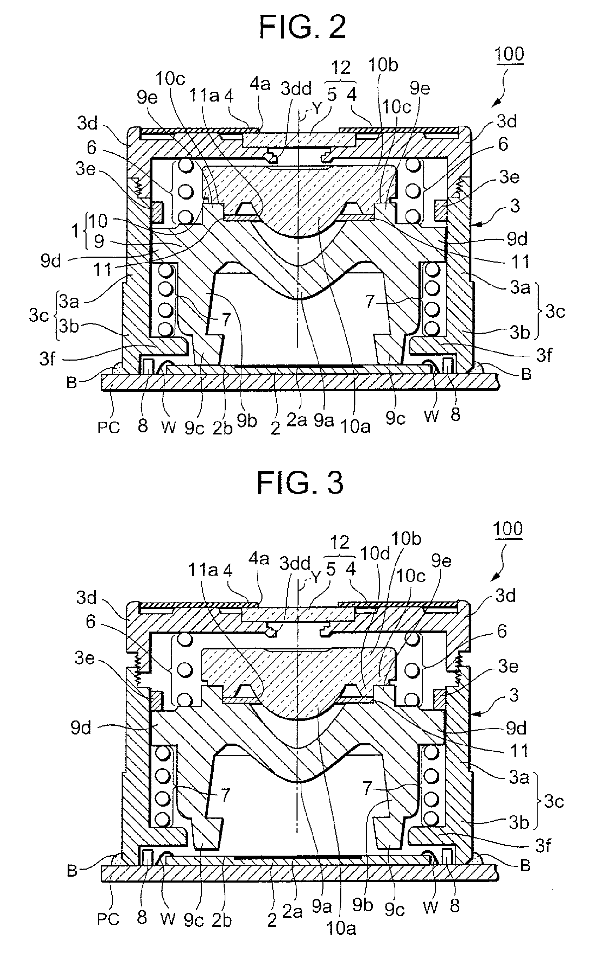

The optical member 1 has a transparent glass or plastic material as its material and, as shown in FIGS. 2 and 3, and comprises a first lens member 9 (a rear optical member) arranged on the substrate PC side (rearward along the optical axis Y), a second lens member 10 (a front optical member) which is provided above this first lens member 9 (frontward along the optical axis Y), and an aperture plate 11 which is provided between the first lens member 9 and the second lens member 10 and adjusts a quantity of a light which enters the first lens member portion 9. It is to be noted that the first lens member 9 and the second lens member 10 have the same optical axis Y.

The first lens member 9 comprises a lens portion 9a having a convex lens shape and a lower leg portion 9b having a tubular shape around the lens portion 9a, and a contact portion 9c ... which comes into contact with the surface of the imaging element 2 in the regular imaging mode is provided at the lower end portion of the lower leg portion 9b.

Further, an extending portion 9d extending toward the side to come into contact with the mirror frame 3 is formed at the side portion of the lower leg portion 9b. One end of the second pressing member 7 is elastically in contact with the lower surface (the rear surface along the optical axis Y) of this extending portion 9d. Furthermore, a protruding portion 3e (which will be described later) which is provided on the inner wall of the mirror frame 3 and protrudes inward in the radial direction of the inner wall is formed above the extending portion 9d (frontward along the optical axis Y) in such a manner that the lower surface of the protruding portion 3e can come into contact with the upper surface of the extending portion 9d.

Moreover, in case of the macro imaging mode, although the optical member 1 including the first lens member 9 and the second lens member 10 laminated on the first lens member 9 moves to be pushed up by the pressing force of the second pressing member 7, the upward movement is restricted when the extending portion 9d comes into contact with the protruding portion 3e, and the optical member 1 is positioned in the macro imaging mode.

Additionally, the lower end of the first pressing member 6 is elastically brought into contact with the upper surface of the lower leg portion 9b of the first lens member 9. Further, in the regular imaging mode, when the first lens member 9 is pressed downward by this first pressing member 6, the first lens member 9 is brought into contact with the imaging element 2, thereby positioning the optical member 1 in the regular imaging mode.

Furthermore, an engagement portion 9e which engages with the second lens member 10 is provided on the upper surface of the lower leg portion 9b. This engagement portion 9e is provided to annularly protrude from the upper surface of the lower leg portion 9b in such a manner that the lens portion 9a is surrounded.

Moreover, the aperture plate 11 which is formed of a material having the light shielding properties and has an opening 11a as an aperture which restricts an F number of the lens portion 9a is fixed around the lens portion 9a on the inner side of this engagement portion 9e by an adhesive.

The second lens member 10 comprises a tubular lower leg portion 10b around the lens portion 10a, and an engagement target portion 10c which is engaged with the engagement portion 9e of the first lens member 9 is provided below this lower leg portion 10b. This engagement target portion 10c has a ring shape protruding from the lower surface of the lower leg portion 10b, and an outer peripheral surface thereof is in contact with the inner peripheral surface of the engagement portion 9e of the first lens member 9 while a lower surface of the same is in contact with the aperture plate 11. Additionally, in this state, the lower surface of the lower leg portion 10b is in contact with the upper surface of the lower leg portion 9b of the first lens member 9. Further, the engagement portion 9e of the first lens member 9 and the engagement target portion 10c are bonded to each other. Therefore, the second lens member 10 can move in the vertical direction (the cross direction along the optical axis Y) in cooperation with the first lens member 9.

Furthermore, when the engagement portion 9e of the first lens member 9 is engaged with the engagement target portion 10c of the second lens member 10, the optical axis Y of the first lens member 9 can be prevented from deviating from the counterpart of the second lens member 10.

The imaging element 2 is an image sensor, and comprises, e.g., a CMOS type image sensor, a CCD type image sensor or the like. The lower surface of the imaging element 2 having a rectangular thin plate shape is attached to the upper surface of the substrate PC. The photoelectric conversion portion 2a as an imaging area in which pixels are two-dimensionally arranged is formed at the center of the upper surface of the imaging element 2. The contact portion 9c of the first lens member 9 comes into contact with a non-imaging area 2b provided outside the photoelectric conversion portion 2a, and a processing portion (not shown) is formed in this area.

Moreover, a plurality of pads (not shown) are arranged in the vicinity of an outer edge of the processing portion. Each pad as a wire terminal is connected with the substrate PC through a wire W. The wire W is connected with a predetermined circuit on the substrate PC connected with the predetermined circuit on the substrate PC.

The mirror frame 3 is a case formed of a material having the light shielding properties, arranged outside the optical member 1 and functions as an outer frame member.

As shown in FIGS. 1 to 3, the mirror frame 3 comprises a main body member 3c including a cylindrical upper portion 3a and a prismatic lower portion 3b, and a lid member 3d which is separately provided at an upper end portion (a front end portion in a direction along the optical axis Y) of the upper portion 3a of the main body member 3c.

Additionally, the lower end portion of the lower portion 3b of the main body member 3c is secured on the substrate PC by an adhesive B.

Further, a protruding portion 3e protruding from the inner peripheral surface is provided on the inner peripheral surface of the upper portion 3a of the main body member 3c between the optical member 1 and the lid member 3d, and the extending portion 9d of the first lens member 9 comes into contact with the lower surface of this protruding portion 3e in case of the macro imaging mode.

Furthermore, there is provided a support portion 3f which protrudes from the inner peripheral surface of the lower portion 3b of the main body member 3c and supports the second pressing member 7. This support portion 3f is engaged with the leg portion 9c of the first lens member 9, and a position of the optical member 1 is restricted to the mirror frame 3 in such a manner the optical member 1 is prevented from rotating around the optical axis Y of the lens portion 9a of the first optical portion 10.

Since the position of the optical member 1 is restricted to the mirror frame 3 in this manner, when the mirror frame 3 is positioned and arranged at a predetermined position of the substrate PC based on, e.g., the later-described positioning electrical component 8, the optical member 1 can be arranged at a predetermined position of the substrate PC, and the center of the photoelectric conversion portion 2a of the imaging element 2 provided to the substrate PC can be matched with the optical axis Y of the lens portion 9a of the first lens member 9 fitted to the mirror frame 3, for example.

Moreover, since the position of the optical member 1 is restricted to the mirror frame 3, the optical member 1 is hard to deviate from a predetermined position in a state where the mirror frame 3 is arranged and fixed at a predetermined position of the substrate PC, and it is easy to maintain a state in which the optical axis Y of the lens portion 9a of the optical member 1 is matched with the center of the photoelectric conversion portion 2a of the imaging element 2, for example.

The lid member 3d of the mirror frame 3 is screwed to the upper end portion of the upper portion 3a, and can move along the optical axis Y in such a manner that it is raised upward (frontward along the optical axis Y) from the upper portion 3a of the mirror frame 3 by swiveling.

Additionally, the lid member 3d has a shape which covers the upper surface of the optical member 1, and is provided with an opening portion 3dd as a first aperture which adjusts a quantity of a light which enters the second lens portion 10.

It is to be noted that the movement of the lid member 3d is carried out by, e.g., a manual operation using, e.g., a non-illustrated lever member or switch member provided to the imaging apparatus 100 or an automatic operation or the like using driving means such as a driving motor, but it is not restricted thereto.

Further, the lid member 3d may be formed of a shape-memory alloy and configured to be deformed and moved along the optical axis Y when heated to a shape-memory temperature in advance.

The douser 4 is attached at the upper end of the lid member 3d by an adhesive or the like. Furthermore, the douser 4 has an opening 4a as a second aperture at the center thereof.

The IR cut filter 5 is formed of a material having infrared absorbing characteristics, and bonded below the opening 4a at the center of the douser 4 by an adhesive or the like.

Moreover, this douser 4 and the IR cut filter 5 constitute a cover member 12. Since the substrate PC, the mirror frame 3 and the cover member 12 are pressed against and bonded to each other in this manner, and hence the imaging apparatus 100 has the dust-proof and damp-proof configuration.

Each of the first pressing member 6 and the second pressing member 7 comprises an elastic member such as a coil spring. Additionally, the first pressing member 6 is elastically interposed between the first lens member 9 an the lid member 3d, and the second pressing member 7 is elastically interposed between the first lens member 9 and the support portion 3f formed below the mirror frame 3.

Further, as shown in FIG. 2, in a state where the lid member 3d is not raised from the upper surface of the main body member 3c, the elasticity of the first pressing member 6 is stronger than that of the second pressing member 7. Therefore, the first lens member 9 is pressed downward (rearward along the optical axis Y) in the drawing by a predetermined pressing force, biased and positioned to come into contact with the imaging element 2.

Furthermore, the state where the first lens member 9 is positioned to come into contact with the imaging element 2 as described above is determined as a state set in the regular imaging mode.

On the other hand, as shown in FIG. 3, when the lid member 3d is raised upward (frontward along the optical axis Y) by swiveling, the elasticity of the first pressing member is weakened, and the elasticity of the second pressing member 7 becomes stronger than the elasticity of the first pressing member 6. Then, the first lens member 9 moves upward (frontward along the optical axis Y) by the pressing force of the second pressing member 7, and the contact portion 9c is separated from the upper surface of the imaging element 2. Then, when the extending portion 9d of the first lens member 9 is brought into contact with the lower surface of the protruding portion 3e of the mirror frame 3, the further movement (a separation distance) is restricted.

It is to be noted that the second lens member 10 laminated on the first lens member 9 also moves upward in cooperation with the first lens member 9.

Furthermore, the state in which the first lens member 9 of the optical member 1 is positioned to come into contact with the protruding portion 3e as described above is determined as a state set in the macro imaging mode.

Moreover, in case of the macro imaging mode, a distance between the optical member 1 and a subject becomes short, namely, a focal distance of the optical member 1 becomes shorter than that in case of the regular imaging mode, and hence close-up shooting and approach shooting of a subject are enabled.

It is to be noted that the optical member 1 is pressed downward in FIG. 2 to come into contact with the imaging element 2 since the pressing force of the first pressing member 6 is larger than the pressing force of the second pressing member 7 in the regular imaging mode, but the lower end of the second pressing member 7 is in contact with the upper surface of the support portion 3f of the main body member 3c, and the buffering effect works due to the elasticity of the second pressing member 7, thereby giving no damage to the imaging element 2.

The positioning electrical component 8 is, e.g., a capacitor, a resistor, a diode and the like, and arranged in proximity to the mirror frame 3 between the imaging element 2 and the mirror frame 3 on the substrate PC in FIG. 2. Additionally, a height from the substrate PC to the upper end portion of the positioning electrical component 8 is larger than a height from the substrate PC to the upper end portion of the imaging element 2. Further, the positioning electrical component 8 serves as a positioning mark for the mirror frame 3 when securing the mirror frame 3 on the substrate PC. Furthermore, since the upper end of the positioning electrical component 8 is higher than the upper end of the imaging element 2, the mirror frame 3 can be prevented from coming into contact with the imaging element 2 to damage the wire W and the like of the imaging element 2.

It is to be noted that the positioning electrical component 8 is not restricted to, e.g., a capacitor, a resistor, a diode and the like, and an electrical component required for the imaging device 100 can be used.

As described above, in the imaging apparatus 100 according to this embodiment of the present invention, the lid member 3d which can move along the optical axis Y is attached to the upper surface of the main body member 3c of the mirror frame 3, the protruding portion 3e protruding from the inner peripheral surface of the main body member 3c is provided between the optical member 1 and the lid member 3d, the first pressing member 6 which presses the optical member 1 toward the substrate PC side is elastically interposed between the lid member 3d and the optical member 1, and the second pressing member 7 which presses the optical member 1 toward the lid member 3d side is elastically interposed between the support portion 3e and the optical member 1.

Further, the pressing force of the first pressing member 6 becomes larger than the pressing force of the second pressing member 7 in a state where the optical member 1 is in contact with the imaging element 2, while the pressing force of the second pressing member 7 becomes larger than the pressing force of the first pressing member 6 and the optical member 1 moves upward (frontward along the optical axis Y) to come into contact with the protruding portion 3e when the lid member 3d moves upward (frontward along the optical axis Y) by a predetermined distance or more. Therefore, the imaging apparatus 100 can perform the imaging processing based on the two focal distances (the imaging modes), i.e., the focal distance (the regular imaging mode) when the optical member 1 is in contact with the imaging element 2 and the macro imaging mode having the focal distance to a subject which is shorter than that of the regular imaging mode.

Furthermore, in the both imaging modes, since the optical member 1 is positioned by contact with the imaging element 2 or contact with the protruding portion 3e by the first pressing member 6 and the second pressing member 7, the accurate optical function can be realized.

Moreover, the focal distances can be adjusted and switched by the arrangement of simple members such as the pressing members and the like or the movement of the lid member 3d, thereby diversifying the optical function without requiring the manufacturing cost or trouble.

Additionally, the lid member 3d is screwed to the main body member 3c, and the lid member 3d can move along the optical axis Y by rotating the lid member 3d, thus realizing the movement of the lid member 3d without providing a complicated mechanism.

It is to be noted that the shape, the configuration and others of each member in the imaging apparatus 100 according to this embodiment of the present invention are not restricted to those descried above.

For example, although the description has been given as to the optical member 1 configured to comprise the first lens member 9 and the second lens member 10, it may be configured to include one lens member only.

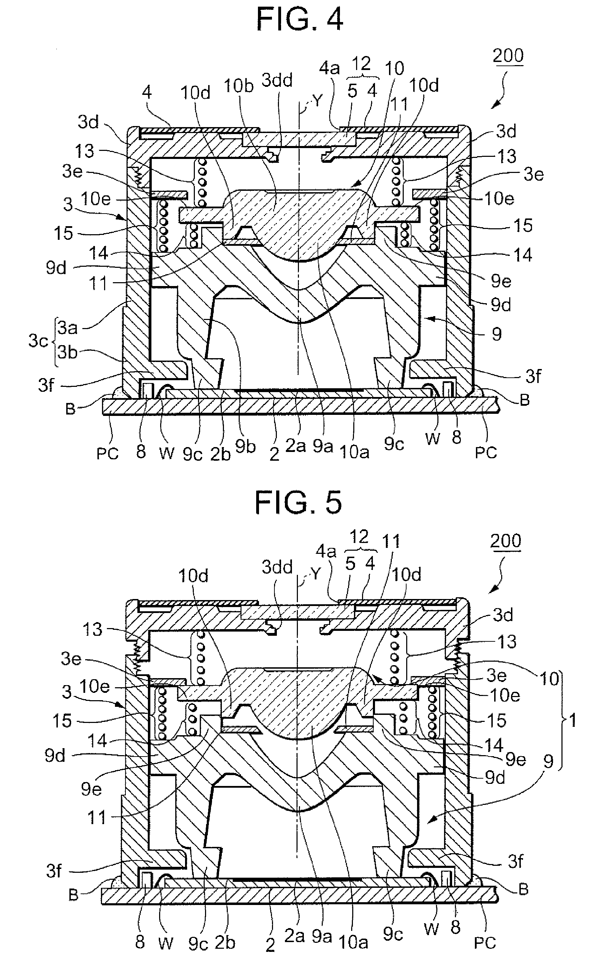

An imaging apparatus 200 which is a modification of the imaging apparatus 100 according to this embodiment will now be described with reference to FIGS. 4 and 5. It is to be noted that like reference numerals denote parts equal to those of the imaging apparatus 100, and a description will be given as to different parts only.

It is to be noted that FIG. 4 is a partially eliminated cross-sectional view of the imaging apparatus 200 in the regular imaging mode and FIG. 5 is a partially eliminated cross-sectional view of the imaging apparatus 200 in the macro imaging mode.

As shown in FIGS. 4 and 5, an extending portion 10e extending in the inner peripheral surface direction of the mirror frame 3 is formed to the second lens member 10 of the optical member 1 in the imaging apparatus 200. This extending portion 10e comes into contact with the protruding portion 3e in the macro imaging mode, and the second lens member 10 is positioned by this contact.

A third pressing member (corresponding to the first pressing member described in claim 4) 13 which presses the second lens member 10 toward the first lens member 9 is elastically interposed between the upper surface of the second lens member 10 and the lower surface of the lid member 3d.

Additionally, a fourth pressing member (corresponding to the second pressing member described in claim 4) 14 which presses the second optical portion 9 upward is elastically interposed between the lower surface of the extending portion 10e of the second lens member 10 and the upper surface of the first lens member 9.

Further, a fifth pressing member (the third pressing member described in claim 4) which presses the first lens member 9 downward is elastically interposed between the lower surface of the protruding portion 3e and the upper surface of the first lens member 9. The pressing force by this fifth pressing member 15 maintains the contact portion 9c of the first lens member 9 in contact with the non-imaging area 2b of the imaging element 2 in both the regular imaging mode and the macro imaging mode without being affected by the pressing forces of the third pressing member 13 and the fourth pressing member 14.

Furthermore, as shown in FIG. 4, in a state where the lid member 3d is not moved, as the regular imaging mode, the pressing force of the third pressing member 13 is larger than the pressing force of the fourth pressing member 14, and hence the second lens member 10 is in contact with the first lens member 9.

Moreover, as shown in FIG. 5, when the lid member 3d is moved upward over a predetermined distance, the pressing force of the fourth pressing member 14 becomes larger than the pressing force of the third pressing member 13, the second lens member 10 is separated from the first lens member 9 and moved upward by the pressing force of the fourth pressing member 14, and the extending portion 10e comes into contact with the protruding portion 3e. As a result, the further movement (the separation movement) is restricted, and positioning in the macro imaging mode is performed. In this macro imaging mode, since the second lens member 10 moves toward a subject, and a focal distance to the subject becomes shorter than that in the regular imaging mode, thereby enabling close-up shooting or approach shooting of the subject.

As described above, according to the imaging apparatus 200, the focal point can be adjusted and the imaging processing in the two imaging modes (the focal distances) can be carried out by moving one of the two laminated optical members.

Additionally, since the focal point is adjusted by moving the second lens member 10 only, the pressing force for the movement can be reduced as compared with the case in which both the first lens member 9 and the second lens member 10 are moved, and hence a reduction in size of the third pressing member 13, the fourth pressing member 15 and the fifth pressing member 16 and size of the imaging apparatus 200 can be realized.

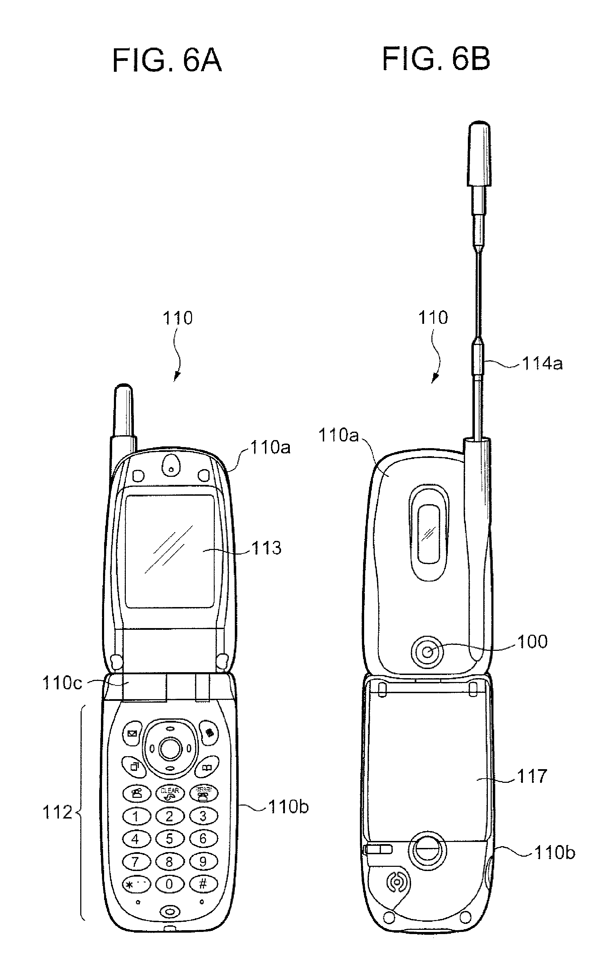

FIGS. 6 are views showing an exterior configuration of a mobile phone which is an example of a portable terminal apparatus to which the present invention is applied. As shown in FIGS. 6, a mobile phone 110 is of a flip type in which a first case 111a and a second case 111b are coupled to each other to be opened and closed by a hinge coupling portion 111c.

As shown in FIG. 6A, a later-described input section 112 and display section 113 are arranged on a surface which is the inner side when closed. A camera button, a function key and others are provided to the input section 112. Further, as shown in FIG. 6B, the above-described imaging apparatus 100 is provided so that imaging is possible with the surface which is the outer surface when closed being directed toward a subject. As shown in FIGS. 6A and 6B, an antenna 114a is arranged at the upper portion of the mobile phone 110. Furthermore, a power supply control section 117 such as a charging pack is provided on the rear surface side in the second case 111b.

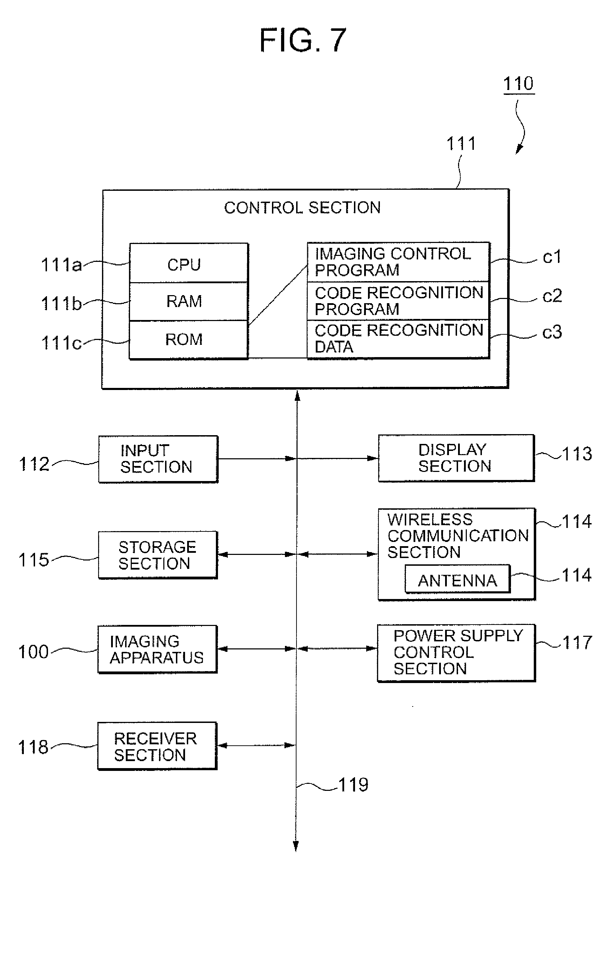

FIG. 7 is a block diagram showing a functional configuration of the mobile phone 110 depicted in FIG. 6. As shown in FIG. 7, the mobile phone 110 comprises a control section 111, an input section 112, a display section 113, a wireless communication section 114 having an antenna 114a, a storage section 115, an imaging apparatus 100, a power supply control section 117, a receiver section 118 and others, and the respective sections are connected with each other through a bus 119.

The control section 111 comprises a CPU (Central Processing Unit) 111a, an RAM (Random Access Memory) 111b constituted of a rewritable semiconductor device, an ROM (Read Only Memory) 111c constituted of a non-volatile semiconductor memory and others.

The ROM 111c stores therein a basic operation control program for the mobile phone 110, a communication processing program, display data which is displayed in the display section 113 and parameter data concerning imaging (default setting data for automatic imaging and default setting data for preview display processing) as well as an imaging control program c1, a code recognition program c2 and code recognition data c3 which are not illustrated in the drawing. In this example, the code recognition data c3 is reference data required when setting a code similarity coefficient (Q) which is used to judge whether a two-dimensional code is included as an information code in image data.

The CPU 111a develops in a work area of the RAM 111b a program specified from various kinds of programs stored in the ROM 111c in accordance with various instructions input from the input section 112 or data input from the wireless communication section 114, and executes various kinds of processing based on the input instructions and the input data in accordance with the program. Further, the CPU 111a stores a processing result in a predetermined area of the RAM 111b and displays the same in the display section 113.

Specifically, the CPU 111a reads the imaging control program c1 stored in the ROM 111c and executes later-described imaging control processing.

As the imaging control processing, the CPU 111a controls the imaging apparatus 100 in accordance with an operation instruction or the like of a user input from the input section 112, stores the captured image data in a predetermined memory or the like of the RAM 111b, and then displays this data in the display section 113 in a preview mode at a frame rate of 25 fps.

Furthermore, the CPU 111a executes code processing which recognizes a two-dimensional code target which may be possibly a two-dimensional code with respect to the captured image data in accordance with the code recognition program c2. Specifically, the CPU 111a compares the captured image data with the code recognition data c3 every five frames to make a judgment upon whether a two-dimensional code is included in the captured image data. More specifically, the CPU 111a compares the captured image data with the code recognition data c3 as similarity coefficient calculation information to calculate a code similarity coefficient with respect to a two-dimensional code target, and recognizes a two-dimensional code target (an information code target) which may be possibly a two-dimensional code or a two-dimensional code based on a value of this code similarity coefficient.

Moreover, when the code similarity coefficient may possibly include a code but there is a two-dimensional code target determined as an inconclusive value, the CPU 111a functions as movement controlling means which controls driving means (not shown) for moving the lid member 3d in order to switch the imaging apparatus 100 to execute the imaging processing based on the macro imaging mode from the regular imaging mode.

Additionally, when a two-dimensional code is recognized in the imaging data, the CPU 111a executes decoding processing of the two-dimensional code and also displays this code in the display section 113.

Further, the CPU 111a executes an operation based on information of the information code subjected to the decoding processing.

The input section 112 comprises a numeric keypad, various kinds of function switches, a mode changeover switch which switches a talk mode and a camera mode and others, and it is used to, e.g., input an instruction for execution of the imaging processing.

The display section 113 comprises an LCD (Liquid Crystal Display) panel and the like, and displays information in a screen based on display data input from the control section 11. Furthermore, the display section 113 displays an image captured by the later-described imaging apparatus 100 in the preview mode, a code information content decoded by the control section 111 and others.

The wireless communication section 114 comprises the antenna 114a which transmits/receives a wireless signal concerning an incoming call or an originating call to/from a wireless base station (not shown), executes a communication protocol for a mobile phone corresponding to a communication scheme complying with, e.g., IMT-2000 (e.g., W-CDMA or cdma2000) with the wireless base station based on an instruction input from the control section 111, and executes transmission/reception of voices or data communication through a communication channel set by this communication scheme.

The storage section 115 stores data or the like which is a result of processing executed by the control section 111. For example, the storage section 115 stores data of an image captured by the imaging apparatus 100, data of a mail transmitted/received through the wireless communication section 114, data or the like of a call history and others.

The imaging apparatus 100 has the above-described configuration, and converts an image input through the optical member 1 into an electrical signal by using the imaging element 2 to generate image data. Further, a CCD type image sensor or the like of the imaging element 2 has a function as an optical sensor which detects an ambient light quantity, and outputs a detection signal corresponding to the ambient light quantity to the control section 111.

Furthermore, the lid member 3d of the imaging apparatus 100 is moved along the optical axis Y by driving means (not shown) driven based on the control by the control section 111. That is, the imaging apparatus 100 is configured in such a manner that the imaging processing based on the regular imaging mode and the macro imaging mode can be switched by the control of the control section 111.

The power supply control section 117 comprises a secondary battery such as a lithium battery, a nickel battery or a nicad battery, and supplies the power having a predetermined voltage to a drive circuit which drives each section of the mobile phone 110 from a positive terminal and a negative terminal in accordance with the control by the control section 111 when the power supply is turned on.

The receiver section 118 has a microphone, a speaker, an A/D converting section and a D/A converting section, subjects transmitted voices of a user input from the microphone to A/D conversion processing, outputs the obtained transmitted voice data to the CPU 111a, and subjects received voice data input from the CPU 111a or sound data such as an incoming call sound, an operation confirmation sound or a shutter sound to D/A conversion processing to output the obtained result from the speaker.

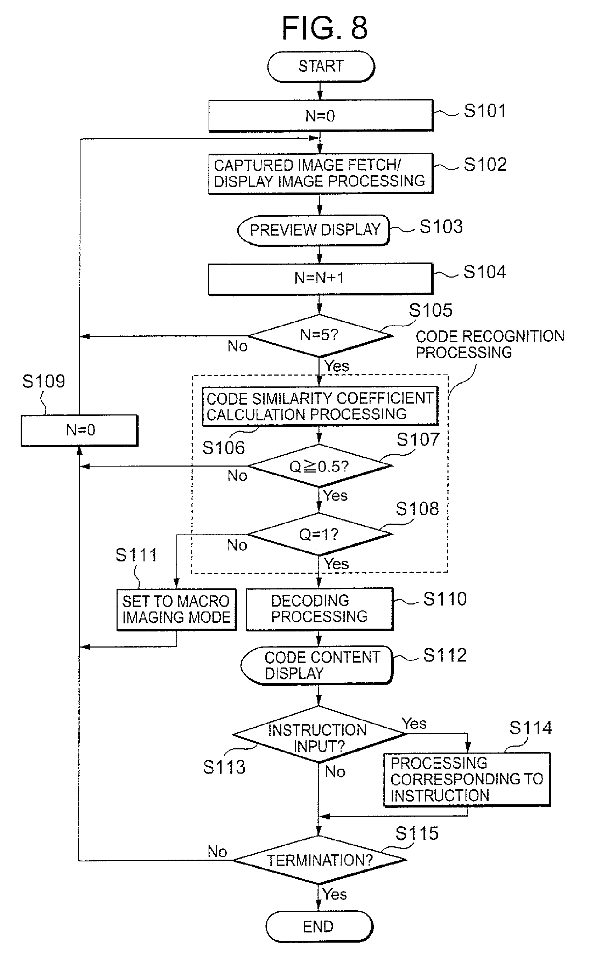

Imaging control processing in the mobile phone 110 will now be described hereinafter with reference to a flowchart of FIG. 8.

When a user of the mobile phone 110 presses a predetermined button of the input section 112, the CPU 111a determines that an imaging processing instruction is input, reads the imaging control program c1 stored in the ROM 111c, develops it in the RAM 111b and starts the control of the imaging processing in accordance with the imaging control program c1.

At this time, the user images a subject by directing the imaging apparatus 100 of the mobile phone 110 toward the subject.

Moreover, specifically, the CPU 111a resets a count number of frames of image data stored in the RAM 111b to 0 (N = 0) (a step S101), and outputs an instruction to start the imaging processing based on the regular imaging mode to the imaging apparatus 100.

Then, the imaging apparatus 100 sequentially outputs to the control section 111 the captured image data of the subject which has been condensed by the optical member 1 and image-formed in the photoelectric conversion portion 2a of the imaging element 2 as the imaging processing based on the regular imaging mode (a step S102).

Subsequently, the CPU 111a of the control section 111 stores the captured image data sequentially input by the imaging apparatus 100 in the RAM 111b, and executes preview display processing which displays the captured image in the display section 113 at a frame rate of 25 fps (a step S103). Furthermore, the CPU 111a counts the number of frames of the image input from the imaging apparatus 100 (N = N + 1) (a step S104) simultaneously with execution of the preview display processing, and judges whether the number of frames is "5" (a step S105).

Then, the CPU 111a advances to a step S106 if it is determined that the number of frames is "5" (the step S105: Yes), while it proceeds to the step S102 if it is determined that the number of frames is not 5 (the step S105: No), and the above-described steps are repeated.

Subsequently, at steps S106 to S108, the CPU 111a reads the code recognition program c2 stored in the ROM 111c, develops the read program in the RAM 111b, and starts the control of the code recognition processing in accordance with this code recognition program c2. Specifically, the CPU 111a compares the captured image data of the subject when the number of frames is "5" with the code recognition data c3 to execute two-dimensional code recognition processing.

Here, as the recognition processing method, there are, e.g., a method which recognizes a two-dimensional code by detecting a predetermined cutout symbol indicating that a two-dimensional code exists in captured image data of a subject, a method which recognizes a two-dimensional code based on the concentration of captured image data of a subject, a method which recognizes a predetermined mosaic shape of a two-dimensional code and others, but the present invention is not restricted thereto.

More specifically, at the step S106, the CPU 111a compares the captured image data with the code recognition data c3 as the similarity coefficient calculation information to calculate a code similarity coefficient (Q) which is used to judge the possibility of a two-dimensional code of the captured image data.

Then, the CPU 111a judges whether a value of the calculated code similarity coefficient (Q) is not less than "0.5" (the step S107), and determines that there is the possibility of a predetermined two-dimensional code and advances to the step S108 if it is determined Q is not less than "0.5" (the step S107: Yes).

On the other hand, if it is determined that the calculated code similarity coefficient (Q) is less than 0.5 (the step S107: No), the CPU 111a determines that the possibility of a two-dimensional code is small, resets the count of frames to "0" (N = 0) (a step S109), then advances to the step S102, and repeats the subsequent preview display processing and the code recognition processing which is carried out every five frames.

In this manner, the CPU 111a executes the two-dimensional code recognition processing with respect to the captured image data of a subject every five frames. Therefore, the processing load of the CPU 111a is reduced, and the influence on the captured image data acquisition processing of a subject and the captured image data preview display processing which are simultaneously executed can be alleviated.

The CPU 111a judges whether the code similarity coefficient (Q) is "1" at the step S108, and determines that there is a two-dimensional code and advances to a step S110 when it is determined that Q is "1" (the step S108: Yes).

On the other hand, if it is determined that the code similarity coefficient (Q) is not smaller than "0.5" but not equal to "1" (the step S108: No), the CPU 111a determines that the possibility of a two-dimensional code is indefinite and recognizes that there is a two-dimensional code target (an information code target). Then, the CPU 111a controls the non-illustrated driving means to move the lid member 3d in a direction of a subject so that the imaging apparatus 100 can perform macro shooting, and the macro imaging mode setting processing is thereby executed (a step S111) and the control advances to a step S109.

In the subsequent step, as the imaging processing in the macro imaging mode, the first lens member 9 of the optical member 1 moves upward (frontward along the optical axis Y) with the movement of the lid member 3d of the imaging apparatus 100 along the optical axis Y by the control of the CPU 111a, and the captured image data of a subject in the macro imaging mode is acquired by using the optical member 1 and the imaging element 2 in a state where the first lens member 9 is in contact with the protruding portion 3e, and the acquired data is displayed in the display section 113 in the preview mode. Further, the CPU 111a executes the code recognition processing every five frames with respect to the captured image data based on the macro imaging mode simultaneously with the imaging processing and the preview display processing in this macro imaging mode. At this time, since the imaging processing in the macro imaging mode is suitable for the case where a distance to a subject is short as compared with the imaging processing in the regular imaging mode, a two-dimensional code recognition ratio is improved, thereby increasing the possibility that a two-dimensional code target is recognized as a two-dimensional code on the assumption that there is the possibility as a two-dimensional code in the regular imaging mode but not indefinite. Based on this, a ratio of recognizing a two-dimensional code in the captured image data of a subject is improved.

At a step S110, the CPU 111a executes the decoding processing for the recognized two-dimensional code, and displays a code information content of this two-dimensional code in the display section 113 (a step S112).

Here, as the code information content displayed in the display section 113, there are, e.g., character information such as a URL address or an e-mail address, arbitrary image information and others.

It is to be noted that when the code information content is, e.g., audio information besides a content which can be displayed in the display section 113, e.g., character information or image information as the code information content, sound generation processing may be executed from the receiver section 118.

Then, the CPU 111a judges whether a signal instructing predetermined processing with respect to the code information content displayed in the display section 113 is input by the operation of the input section 112 by a user (a step S113), and executes processing corresponding to the instruction (a step S114) and advances to a step S115 when it is determined that the instruction signal is input (the step S113: Yes).

Here, the predetermined processing with respect to the code information content is, e.g., an instruction of connection to a URL address when the code information content is the URL address, it is an instruction to create an e-mail to an e-mail address when the code information content is the e-mail address, it is processing of saving in an address book or the like when the code information content is a telephone number, an email-address or the like, and it is processing of saving a displayed image in the display section 113 or the like in any other case, but the present invention is not restricted thereto.

On the other hand, if it is determined that there is no input of the instruction signal from a user at the step S113 (the step S113: No), the CPU 111a advances to a step S115.

Subsequently, the CPU 111a judges whether an imaging processing end instruction is input by the operation of the input section 112 by a user (the step S115), and the instruction to terminate the imaging processing is output to the imaging apparatus 100 to terminate this imaging control processing if it is determined that the imaging processing end instruction is input (the step S115: Yes).

On the other hand, if it is determined that the imaging processing end instruction is not input (the step S115: No) the CPU 111a advances to the step S109 and repeats the step S109 and the subsequent steps.

As described above, in the imaging control processing, the processing of recognizing predetermined two-dimensional code data in the captured image data and the two-dimensional code data decoding processing are automatically executed simultaneously with the processing of acquiring the captured image data of a subject by the imaging apparatus 100 and the captured image data preview display processing. Therefore, a user can automatically read and decode a two-dimensional code by performing the same operation as that of the regular imaging processing without performing the troublesome setting in order to recognize and decode a two-dimensional code given to, e.g., a card or a magazine, thereby improving the usability.

Further, for example, when the captured image data based on the regular imaging mode may be out of focus or include many noises, a two-dimensional code cannot be clearly recognized, but if there is such a possibility, the imaging apparatus 100 is controlled so that the processing is automatically switched to the imaging processing based on the macro imaging mode appropriate to recognition of a two-dimensional code. Therefore, the two-dimensional code recognition accuracy can be increased without imposing the trouble of changing the setting of the imaging mode to a user.

Furthermore, when the possibility that a two-dimensional code is included in the captured image data based on the regular image mode is low or when a two-dimensional code can be clearly recognized, the imaging mode is not switched, which is efficient.

It is to be noted that the content described in conjunction with this embodiment according to the present invention is a preferred example of the mobile phone 110 according to the present invention, and the present invention is not restricted thereto. For example, the method of moving the lid member 3d of the imaging apparatus 100 may be of any type. Moreover, as to the imaging apparatus in this mobile phone 110, the example in which the imaging apparatus 100 is mounted has been described, but it is possible to adopt a configuration in which the imaging apparatus 200 as a modification of the imaging apparatus 100 is mounted.

Additionally, although the above has described the example of the information code by using a two-dimensional code, the present invention is not restricted to the two-dimensional code, and it is possible to use any information code, e.g., a bar code or a color code.

Further, in the above imaging control processing, the description has been given as to the configuration in which, when a two-dimensional code is decoded, its code information content is displayed in the display section 113 and then various kinds of processing corresponding to the information content of the two-dimensional code are executed based on an instruction for predetermined processing by a user, but it is possible to adopt a configuration in which predetermined processing is automatically executed when a code information content is decoded by the CPU 111a.

Besides, a detailed configuration and a detailed operation of the mobile phone 110 in the embodiment according to the present invention can be appropriately changed without departing from the scope of the present invention.

Furthermore, the portable terminal apparatus according to the present invention is not restricted to the mobile phone 110, and it may be a personal computer, a PDA or the like.

Moreover, it is considered that the imaging apparatus according to the present invention can be incorporated in various kinds of products such as a mobile phone, a personal computer, a PDA, an AV device, a television set, a home electric appliance and others.

## Claims

1. An imaging apparatus comprising: a substrate having an imaging element provided on an upper surface thereof; an optical member, which is separably in contact with the upper surface of the substrate or the imaging element and condenses an incident light on the imaging element; and an outer frame member, which covers the imaging element and the optical member and including a main body member being fixedly provided on the substrate, a lid member attached on an end side of the main body member in such a manner that the lid member can move along an optical axis of the optical member, and a protruding portion which is fixedly provided at a predetermined position between the optical member and the lid member to protrude inwardly in a radial direction from an inner peripheral surface of the main body member,
the imaging apparatus being **characterized by** that the imaging apparatus comprises:
a first pressing member which is elastically interposed between the lid member and the optical member and presses the optical member toward the substrate side; and
a second pressing member which is elastically interposed between a support member formed below the main body member and the optical member and presses the optical member toward the lid member side,
wherein a pressing force of the first pressing member is larger than a pressing force of the second pressing member in a state where the optical member is in contact with the substrate or the imaging element, and the pressing force of the second pressing member is larger than the pressing force of the first pressing member and the optical member moves frontward along the optical axis to come into contact with the protruding portion in a state where the lid member is moved frontward along the optical axis over a predetermined distance.

2. The imaging apparatus according to claim 1 being **characterized by** that the lid member is screwed to the main body member, and the lid member is capable of moving along the optical axis by rotating the lid member.

3. The imaging apparatus according to claim 1 or 2 being **characterized by** that the optical member comprises an extending portion, which extends to the side and supports the second pressing member on a rear surface thereof, and the main body member further comprises a support portion which protrudes from the inner peripheral surface and supports the second pressing member on a front surface thereof.

4. An imaging apparatus comprising: a substrate having an imaging element provided on an upper surface thereof; an optical member, which is separably in contact with the upper surface of the substrate or the imaging element, comprises a front optical member and a rear optical member, which are laminated in a cross direction so that they have the same optical axis, and condenses an incident light on the imaging element; and an outer frame member, which covers the imaging element and the optical member, and comprises a main body member fixedly provided on the substrate, a lid member attached on an end side of the main body member in such a manner that the lid member can move along an optical axis of the optical member, and a protruding portion which is fixedly provided at a predetermined position between the optical member and the lid member to protrude inwardly in a radial direction from an inner peripheral surface of the main body member,
the imaging apparatus being **characterized by** that the imaging apparatus comprises:
a first pressing member, which is elastically interposed between the lid member and the front optical member and presses the front optical member toward the rear optical member side;
a second pressing member, which is elastically interposed between the front optical member and the rear optical member and presses the front optical member toward the lid member side; and
a third pressing member, which presses the rear optical member toward the substrate side,
wherein a pressing force of the first pressing member is larger than a pressing force of the second pressing member in a state where the front optical member is in contact with the rear optical member, and the pressing force of the second pressing member is larger than the pressing force of the first pressing member and the front optical member moves frontward along the optical axis to come into contact with the protruding portion in a state where the lid member is moved frontward along the optical axis over a predetermined distance.

5. The imaging apparatus according to one of claims 1 to 4 being **characterized by** that the lid member is formed of a shape-memory alloy, and configured to be deformed and moved along the optical axis when heated.

6. A portable terminal apparatus comprising the imaging apparatus according to one of claims 1 to 5.

7. The portable terminal apparatus according to claim 6 being **characterized by** that the portable terminal apparatus comprises a movement controlling means for performing the control to move the lid member of the imaging apparatus along the optical axis.
